# EUROPÄISCHE PATENTSCHRIFT

(11) **EP 2 490 275 B1**
(45) Veröffentlichungstag und Bekanntmachung des Hinweises auf die Patenterteilung: **02.04.2014**
(21) Anmeldenummer: 11305159.3
(22) Anmeldetag: 16.02.2011
(51) Int. Cl.: H01L 39/24

(54) **Verfahren zur Herstellung eines supraleitfähigen elektrischen Leiters**
Method for producing a superconductive electric conductor
Procédé de fabrication d'un conducteur électrique supraconducteur

(43) Veröffentlichungstag der Anmeldung: 22.08.2012
(73) Patentinhaber: Nexans, 75008 Paris (FR)
(72) Erfinder: Soika, Rainer, 30559 Hannover (DE)
(74) Vertreter: Döring, Roger

(56) Entgegenhaltungen:
- JP-A- 5 294 630
- JP-A- 2009 187 743

## Beschreibung

Die Erfindung bezieht sich auf ein Verfahren zur Herstellung eines supraleitfähigen elektrischen Leiters auf Basis von Wismut-Strontium-Barium-Kupfer-Oxid (BSCCO), mit welchem zunächst eine Anzahl von vorgefertigten BSCCO-Filamenten in eine gemeinsame, rohrförmig geschlossene Hülle aus Silber bzw. aus einer Silberlegierung eingebracht wird, mit welchem danach die mit den Filamenten bestückte Hülle zu einem Band verformt wird, mit welchem anschließend die Dicke des Bandes auf einen vorgegebenen Wert reduziert wird, mit welchem die Stromtragfähigkeit des Bandes während der Fertigung im kontinuierlichen Durchlauf gemessen wird und mit welchem Bereiche mit verminderter Stromtragfähigkeit während der laufenden Fertigung zumindest als Fehlerstellen markiert werden.

Heute im Einsatz befindliche supraleitfähige Leiter werden auch als HochtemperaturSupraleiter (HTSL) bezeichnet. Sie bestehen aus einem Verbundwerkstoff, der keramisches Material enthält. Derartige keramische Materialien sind beispielsweise BSCCO (Wismut-Strontium-Kalzium-Kupfer-Oxid) als Material der 1. Generation oder ReBCO (Rare-earth-Barium-Kupfer-Oxid), insbesondere YBCO (Yttrium-Barium-Kupfer-Oxid), als Materialien der 2. Generation. Der elektrische Gleichstromwiderstand solcher supraleitfähiger Leiter ist bei ausreichender Kühlung Null, solange eine bestimmte Stromstärke nicht überschritten wird. Ausreichend niedrige Temperaturen, um ein derartiges Material in den supraleitfähigen Zustand zu bringen, liegen beispielsweise zwischen 67 K und 90 K. Geeignete Kühlmittel sind beispielsweise Stickstoff, Helium, Neon und Wasserstoff oder Gemische dieser Stoffe.

Supraleitfähige Leiter auf der Basis von BSCCO lassen sich mit dem eingangs geschilderten, grundsätzlich bekannten Verfahren relativ einfach herstellen. Es werden dazu beispielsweise aus Silberröhrchen bestehende Filamente hergestellt, die mit BSCCO gefüllt sind, von denen eine größere Anzahl in eine gemeinsame Hülle aus Silber eingebracht wird. Die mit Filamenten gefüllte Hülle wird zu einem Band geformt und die Dicke des Bandes wird abschließend so weit reduziert, daß sich ein in üblicher Technik zu verarbeitender Leiter ergibt. Seine Dicke liegt etwa bei 0,25 mm. Zur mechanischen Stabilisierung einer solchen dann als Innenleiter bezeichneten, mit Filamenten gefüllten Hülle kann auf beiden Seiten desselben zusätzlich eine beispielsweise aus Edelstahl oder aus einer Kupferlegierung bestehende Schicht aufgebracht werden, wodurch die Dicke des Bandes auf etwa 0,45 mm erhöht wird. Ein aus einem solchen BSCCO-Band bestehender Leiter hat in beiden Ausführungsformen den Vorteil, daß eine Beschädigung desselben in einem supraleitfähigen Kabel nicht zu einem vollständigen Ausfall desselben führt, weil eine große Anzahl von Filamenten vorhanden ist, von denen in der Regel nur ein Teil beschädigt wird, und weil das Silber aufgrund seiner hohen elektrischen Leitfähigkeit zusätzlich einen wirksamen Ersatzleiter darstellt. Trotzdem muß das BSCCO-Band im Auslieferungszustand aber als elektrischer Leiter fehlerfrei sein. Dazu wird während der Herstellung seine Stromtragfähigkeit kontinuierlich gemessen. Dabei festgestellte Fehlerstellen werden in bekannter Technik markiert und aus dem Band herausgeschnitten. Die Enden der dadurch entstehenden Bandabschnitte werden danach übereinander gelegt und fest miteinander verbunden. Das Band liegt dadurch an den Verbindungsstellen doppellagig vor, mit einer Dicke einer Verbindungsstelle von etwa 0,5 mm bzw. 0,9 mm. Dadurch wird die Weiterverarbeitung des BSCCO-Bandes als Leiter in einem Kabel erschwert, weil die Verbindungsstellen nicht nur eine störende Verdickung darstellen, sondern auch die Biegbarkeit des Leiters beeinträchtigen.

Der Erfindung liegt die Aufgabe zugrunde, das eingangs geschilderte Verfahren so weiterzubilden, daß die erforderliche Stromtragfähigkeit des BSCCO-Bandes an Fehlerstellen auf einfachere Art und Weise eingestellt werden kann.

Diese Aufgabe wird gemäß der Erfindung dadurch gelöst, daß im Bereich von Fehlerstellen zumindest auf einer Seite des Bandes Streifen festhaftend aufgebracht werden, die aus einem bandförmigen Träger bestehen, der mit einem hochtemperatur-supraleitfähigen Material (HTSL-Material) beschichtet ist, und die etwa die gleiche Breite wie das BSCCO-Band sowie eine maximale Dicke von 0,1 mm haben, wobei das HTSL-Material dem Band zugewandt ist.

Bei Einsatz dieses Verfahrens braucht das BSCCO-Band bei Feststellung eines Fehlers nicht aufgetrennt zu werden zu werden, wodurch seine Fertigung wesentlich vereinfacht wird. Die erforderliche Stromtragfähigkeit eines aus dem entsprechenden Band hergestellten elektrischen Leiters wird durch die an festgestellten Fehlerstellen aufgebrachten, HTSL-Material aufweisenden Streifen sichergestellt. Ein solcher Streifen mit HTSL-Material kann bereits während der Herstellung des BSCCO-Bandes, aber auch in einem folgenden Arbeitsgang aufgebracht werden. Wenn das Band ohne stabilisierende Beschichtung bleibt, kann der Streifen aus HTSL-Material so angebracht werden, daß das HTSL-Material direkt am Band anliegt. Derartige Streifen mit HTSL-Material sind bekannt und auf dem Markt erhältlich. Sie haben eine maximale Dicke von 0,1 mm und werden mit Vorteil mit einer Dicke von 0,05 mm eingesetzt. An der mit diesem Verfahren "reparierten" Fehlerstelle hat das BSCCO-Band dann eine Dicke von 0,3 mm, wenn der Streifen nur auf einer Seite eines 0,25 mm dicken Bandes aufgebracht wird. Sie trägt damit nur unwesentlich auf, so daß die Weiterverarbeitung des BSCCO-Bandes als Leiter eines supraleitfähigen Kabels nicht behindert wird.

Als HTSL-Material für den Streifen wird mit Vorteil YBCO eingesetzt.

Das Verfahren nach der Erfindung wird anhand der Zeichnungen in Ausführungsbeispielen erläutert.

Es zeigen:
Fig. 1 in schematischer Darstellung eine Anordnung zur Herstellung eines BSCCO-Bandes.
Fig. 2 eine Draufsicht auf ein BSCCO-Band.
Fig. 3 eine Seitenansicht des Bandes nach Fig. 2.
Fig. 4 eine gegenüber Fig. 3 ergänzte Ausführungsform des Bandes.

Entsprechend den weiter oben gegebenen Erläuterungen kann das BSCCO-Band mit dem Verfahren nach der Erfindung so hergestellt werden, daß die Hülle aus Silber bzw. aus einer Silberlegierung ohne weitere Laminierung bleibt. Es kann aber auch zur Stabilisierung des BSCCO-Bandes beidseitig eine beispielsweise aus Edelstahl oder aus einer Kupferlegierung bestehende Schicht auf dasselbe aufgebracht werden. Die Stromtragfähigkeit des BSCCO-Bandes kann dann am nicht laminierten aber auch am laminierten Produkt gemessen werden. Bei einem im obigen Sinne laminierten BSCCO-Band wird der mindestens eine HTSL-Material aufweisende Streifen an einer Fehlerstelle auf die der Stabilisierung dienende Schicht aufgebracht. Stellvertretend für alle möglichen Ausführungsformen wird das Verfahren im folgenden für die Herstellung und die "Reparatur" eines BSCCO-Bandes erläutert, das eine nicht beschichtete Hülle aus Silber bzw. aus einer Silberlegierung hat.

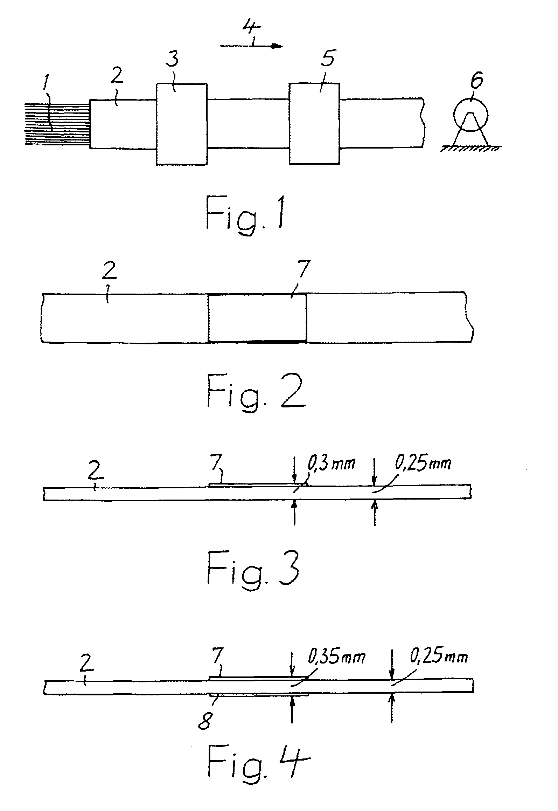

Mit einer Anordnung nach Fig. 1 wird eine Vielzahl von vorgefertigten BSCCO-Filamenten 1 in eine gemeinsame Hülle aus Silber bzw. aus einer Silberlegierung eingebracht. Die Hülle wird anschließend mit den umschlossenen Filamenten 1 zu einem BSCCO-Band 2 geformt - im folgenden kurz "Band 2" genannt. Das Band 2 wird in einer Einrichtung 3 so weit in seinen Abmessungen reduziert, bis es eine Dicke von etwa 0,25 mm hat. Während der Fertigung wird es mit kontinuierlichem Vorschub in Richtung des Pfeiles 4 bewegt. Das Band 2 durchläuft hinter der Einrichtung 3 eine Meßeinrichtung 5, in welcher seine Stromtragfähigkeit gemessen wird. Fehlerstellen, an denen die Stromtragfähigkeit kleiner als ein vorgegebener Wert ist, werden markiert. Das Band 2 kann abschließend auf eine nur schematisch angedeutete Spule 6 aufgewickelt werden.

Während der Fertigung des Bandes 2 können gemäß Fig. 3 Streifen 7 auf in der Meßeinrichtung 5 festgestellten Fehlerstellen mit verminderter Stromtragfähigkeit auf das Band 2 aufgebracht werden, die aus einem vorzugsweise mit YBCO beschichteten Träger bestehen. Die Streifen 7 sind mit Vorteil 0,05 mm dick. Sie werden so auf das Band 2 aufgebracht und fest mit demselben verbunden, daß das YBCO direkt bzw. unmittelbar auf demselben aufliegt. Die entsprechende "Reparaturstelle" hat eine Dicke von 0,3 mm, wenn das Band 2 eine Dicke von 0,25 mm hat.

Eine Fehlerstelle des Bandes 2 kann gemäß Fig. 4 auch dadurch "repariert" werden, daß neben dem Streifen 7 auch auf der anderen Seite desselben ein Streifen 8 mit YBCO aufgebracht wird. Auch dann ist die Dicke der "Reparaturstelle" nicht wesentlich bzw. störend vergrößert. Sie liegt bei 0,35 mm.

Die im Vorangehenden beschriebene Reparatur des Bandes 2 kann auch unabhängig von der laufenden Fertigung zu einem späteren Zeitpunkt erfolgen.

## Patentansprüche

1. Verfahren zur Herstellung eines supraleitfähigen elektrischen Leiters auf Basis von Wismut-Strontium-Barium-Kupfer-Oxid (BSCCO), mit welchem zunächst eine Anzahl von vorgefertigten BSCCO-Filamenten in eine gemeinsame, rohrförmig geschlossene Hülle aus Silber bzw. aus einer Silberlegierung eingebracht wird, mit welchem danach die mit den Filamenten bestückte Hülle zu einem Band verformt wird, mit welchem anschließend die Dicke des Bandes auf einen vorgegebenen Wert reduziert wird, mit welchem die Stromtragfähigkeit des Bandes während der Fertigung im kontinuierlichen Durchlauf gemessen wird und mit welchem Bereiche mit verminderter Stromtragfähigkeit während der laufenden Fertigung zumindest als Fehlerstellen markiert werden, **dadurch gekennzeichnet, daß** im Bereich von Fehlerstellen zumindest auf einer Seite des Bandes (2) Streifen (7) festhaftend aufgebracht werden, die aus einem bandförmigen Träger bestehen, der mit einem hochtemperatur-supraleitfähigen Material (HTSL-Material) beschichtet ist, und die etwa die gleiche Breite wie das Band (2) sowie eine maximale Dicke von 0,1 mm haben, wobei das HTSL-Material dem Band (2) zugewandt ist.

2. Verfahren nach Anspruch 1, **dadurch gekennzeichnet, daß** Streifen (7) aus HTSL-Material mit einer Dicke von 0,05 mm verwendet werden.

3. Verfahren nach Anspruch 1 oder 2, **dadurch gekennzeichnet, daß** Streifen (7) aus HTSL-Material direkt auf die Hülle aus Silber bzw. aus einer Silberlegierung aufgebracht werden.

4. Verfahren nach Anspruch 1 oder 2, **dadurch gekennzeichnet, daß** an einer Fehlerstelle auf beiden Seiten des Bandes (2) je ein Streifen (7,8) mit HTSL-Material angebracht wird.

5. Verfahren nach einem der Ansprüche 1 bis 4, **dadurch gekennzeichnet, daß** der bzw. die Streifen (7,8) mit HTSL-Material während der laufenden Fertigung angebracht wird bzw. werden.

6. Verfahren nach einem der Ansprüche 1 bis 5, **dadurch gekennzeichnet, daß** als HTSL-Material Yttrium-Barium-Kupfer-Oxid (YBCO) verwendet wird.

## Claims

1. A method for the manufacturing of a superconductive electrical conductor on the basis of Bismuth-Strontium-Barium-Copper-Oxide(BSCCO), by which at first a plurality of prefabricated BSCCO-filaments is inserted into a common tubelike casing made of silver or a silver alloy, by hich thereafter the casing containing the filaments is formed into a tape, by which then the ampacity of the tape is measured continuously during manufacturing and by which defective areas with a reduced ampacity are marked during the continuous manufacturing, **characterized in that** at the defective areas patches (7) are adhered to the tape (2) at least on one side of the same, which consist of a ribbon like support which is coated with a hightemperature-superconductive material (HTSL-material), and which have nearly the same width as the tape (2) and a maximum thickness of 0,1 mm, wherein the TSL-material turns towards the tape (2).

2. A method according to claim 1, **characterized in that** patches (7) made of HTSL-material are used which have a thickness of 0,05 mm.

3. A method according to claim 1 or 2, **characterized in that** patches (7) made of HTSL-material are applied directly to the casing consisting of silver or a silver alloy.

4. A method according to claim 1 or 2, **characterized in that** at a defective area a patch (7,8) made of HTSL-material is applied an both sides of the tape (2) respectively.

5. A method according to one of the claims 1 to 4, **characterized in that** the patch or patches (7,8) made of HTSL-material is or are applied during the course of manufacture.

6. A method according to one of the claims 1 to 5, **characterized in that** Yttrium-Barium-Copper-Oxide (YBCO) is used as the HTSL-material.

## Revendications

1. Procédé de fabrication d'un conducteur électrique supraconducteur à base d'oxyde de bismuth-strontium-baryum-cuivre (BSCCO), dans lequel on introduit d'abord un nombre de filaments de BSCCO préfabriqués dans une gaine commune tubulaire fermée en argent ou en un alliage d'argent, dans lequel on déforme ensuite la gaine garnie des filaments en une bande, dans lequel on réduit ensuite l'épaisseur de la bande à une valeur prédéterminée, dans lequel on mesure la capacité de transport de courant de la bande pendant la fabrication en défilement continu et dans lequel on marque des zones de capacité de transport de courant réduite pendant la fabrication courante au moins comme zones de défaut, **caractérisé en ce que** l'on applique dans la région de zones de défaut, au moins sur un côté de la bande (2), des bandelettes autoadhésives (7), qui se composent d'un support en forme de bande, qui est revêtu d'un matériau supraconducteur pour haute température (matériau HTSL), et qui ont environ la même largeur que la bande (2) ainsi qu'une épaisseur maximale de 0,1 mm, le matériau HTSL étant tourné vers la barde (2).

2. Procédé selon la revendication 1, **caractérisé en ce que** l'on utilise des bandelettes (7) en matériau HTSL d'une épaisseur de 0,05mm.

3. Procédé selon la revendication 1 ou 2, **caractérisé en ce que** l'on applique des bandelettes (7) en matériau HTSL directement sur la gaine en argent ou en un alliage d'argent.

4. Procédé selon la revendication 1 ou 2, en ce que l'on applique une bandelette (7, 8) avec du matériau HTSL respectivement sur chacun des deux côtés de la bande (2) dans une zone de défaut.

5. Procédé selon l'une quelconque des revendications 1 à 4, **caractérisé en ce que** l'on applique la ou les bandelette(s) (7, 8) avec du matériau HTSL pendant la fabrication courante.

6. Procédé selon l'une quelconque des revendications 1 à 5, **caractérisé en ce que** l'on utilise comme matériau HTSL de l'oxyde de Yttrium-Baryum-Cuivre-Oxyde (YBCO).
